# EUROPEAN PATENT APPLICATION

(11) **EP 0 860 229 A1**
(43) Date of publication of application: **26.08.1998**
(21) Application number: 98301350.9
(22) Date of filing: 24.02.1998
(51) Int. Cl.: B23K 3/06

(54) **Soldering apparatus**

(30) Priority: 24.02.1997 GB 9703790
(71) Applicant: PILLARHOUSE INTERNATIONAL LIMITED, Chelmsford, Essex CM1 3BY (GB)
(72) Inventor: Ciniglio, Alexander James, Great Dunmow, Essex, CM6 1JN (GB)
(74) Representative: Luckhurst, Anthony Henry William

(57) **Abstract**

To dip solder component leads 68, 70 to a printed circuit board 28, the leads are dipped into a bath of solder, and the board rotated about an axis B-B at and angle to the rows of leads 68, 70 as the board is raised form the solder bath. When several components are to be soldered, they may be soldered in turn and the rotation of the board determined for each component.

## Description

The present invention relates to a soldering apparatus. More particularly, the invention relates to a dip soldering apparatus for soldering components to a printed circuit board (PCB).

US-A-5,611,480 describes a dip soldering apparatus in which a PCB is lowered to dip component leads into a solder bath and then rotated as it is lifted away from the bath. This has the advantage of reducing the likelihood of bridging between closely spaced component leads. One difficulty with this system is controlling the angle and rate of withdrawal of the leads from the solder surface, particularly when several, spaced apart, components are being soldered .

One aspect of the present invention provides dip soldering apparatus for soldering to a PCB components having a plurality of leads, comprising a container for molten solder, means for lowering the board and means for raising the board to dip the leads of components or groups of components in turn into the surface of the solder, wherein the means for raising the board include means for rotating the board about an axis as the leads are removed from the solder surface, the axis of rotation of the board being determined for each component or group of components in turn.

In operation, when the component is a printed circuit board having a plurality of groups of leads to be soldered, a first group of leads is dipped into the solder meniscus and the board rotated about an axis near one end of the group of leads as the board is raised to withdraw the leads. The board is then re-positioned and lowered to dip a second group of leads. The board is then rotated about an axis near an end of the second group of leads as the board is raised to withdraw the leads. The position of the axis of rotation, relative to each group of leads or to the nozzle, can be kept constant. It will appreciated that typically the leads of each component in turn are soldered, but closely spaced components may be soldered at the same time, also a component having spaced groups of leads may be soldered in more than one operations.

By repositioning the PCB relative to the nozzle and thus determining the axis of rotation for each component in turn, greater control can be exercised and so a more reproducible soldering operation is achieved. It will be appreciated that other parameters such as the speed of rotation may also be determined separately for each component or group of components.

When the board is rotatable in a single vertical plane, it may be rotated through 90 degrees to solder rows of leads which extend at right angles to the plane of rotation.

Preferably, however, means is provided for rotating the board in more than one plane.

When soldering an IC or other device having closely spaced leads arranged on sides of a square, for example, it is difficult to solder the leads without bridging, because leads of one row (one side of the square) will leave the solder in unison.

Thus, in accordance with a particularly preferred aspect of the invention, means is provided to rotate the board in a plane which is angled to the rows of the leads. Thus, for example, the boards may be rotated in a plane which is along a diagonal of the array of leads.

When withdrawing a component at an angle, the leads which are withdrawn last from the solder receive greater heating, which can give a different uptake of solder on leads across the component. Also this can result in lead to overheating of some leads.

Another aspect of the invention provides a soldering process in which a component is rotated, in a first direction as its leads are dipped into the solder bath to dip the leads sequentially into the solder, and then rotated in the opposite direction as the component leads are withdrawn from the bath. In this way, the leads will have substantially the same degree of exposure to the heat of the bath.

The invention will be further described by way of example with reference to the accompanying drawings, in which:
Figure 1 shows schematically a soldering apparatus in accordance with the invention;
Figure 2 shows a control diagram for the apparatus of Figure 1;
Figure 3 shows a soldering operation, and
Figure 4 shows a schematic view of a modification of the embodiment of Figure 1.

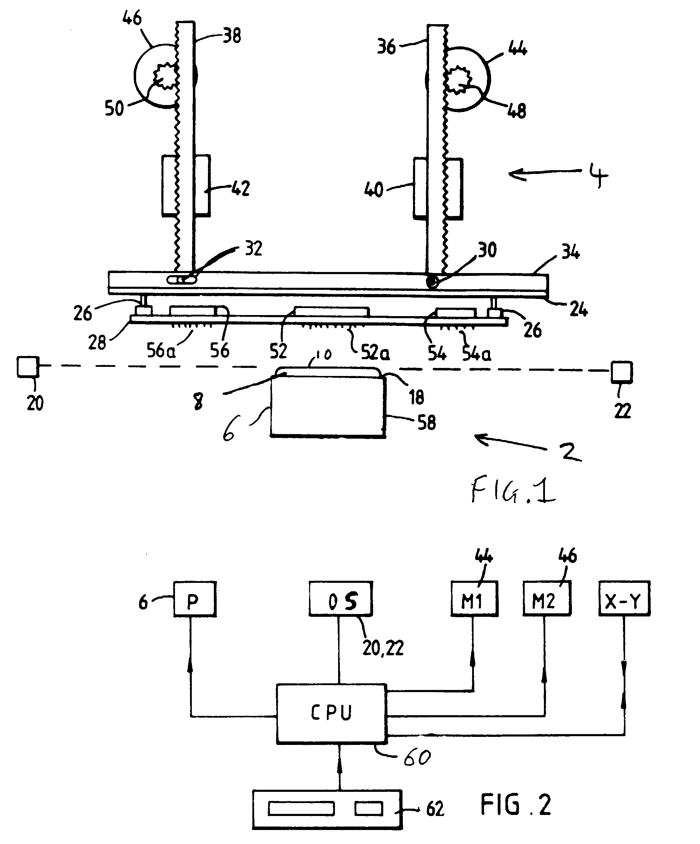

Referring to Figure 1, a soldering apparatus comprises an applicator 2 which provides a surface of molten solder at a predetermined height, and a component handling mechanism 4 for dipping component leads into the molten solder.

The applicator 2 may take various forms as well known in the art. The applicator 2 shown comprises a pot 6 containing molten solder 8. The pot 6 is filed by dipping it below the surface of a bath of molten solder (not shown) and then raising it to a predetermined height, the solder meniscus 10 being determined by an optical sensor 20, 22. By way of another example. the pot 8 could be in the form of a nozzle, with molten solder 8 being pumped through the nozzle and overflowing the nozzle, the nozzle being kept at a fixed height.

The component handling mechanism 4 comprises a table 24 having suckers 26 which hold the component, in this case a PCB 28.

The table 24 is supported on side beams 34 which are carried by laterally extending guide rails 30,32. The first guide rail 30 is journalled in the side beams 34 to allow rotational movement between the rail 30 and side beams 34 without significant play in the X, Y or Z directions. The second guide rail 32 is journalled in elongate bearings which will allow sliding of the rail 32 relative to the beams 34 in the X direction, as well as rotation, and again without significant play in the Y and Z directions.

The rails 30,32 are carried by respective vertically extending racks 36,38 which slide in guides 40,42. The racks are driven vertically by stepper motors 44,46 with drive pinions 48,50.

The component handling mechanism 4 is carried on an XY mechanism (not shown) for moving the mechanism in the X-Y plane relative to the applicator 2, and between pick-up and deposit station (not shown) at either side of the applicator 2, in the X direction, where the table 24 is lowered by actuation of the motors 44 to pick up and deposit a board 28 by suckers 26.

A first method of operation of the device will now be described.

To perform a soldering operation to solder a component 52 to the PCB 28, the component handling mechanism 4 is moved by the X-Y mechanism to a pick-up station and lowered to pick up a PCB 28 using the suckers 26.

The table 24 is then raised and the component handling mechanism 4 translated to a position over the nozzle 14.

With the solder meniscus 10 at a datum level, detected by the optical sensor 20,22, the board 28 is held horizontal and lowered by actuation of the motors 44,46 to dip the leads 52a of component 52 into the solder meniscus 16. Motors 44,46 are then actuated to raise the board 28 withdrawing the leads from the board. The motors 44 are actuated at different speeds to cause the board to pivot from the horizontal as it is raised away from the meniscus 16. In this way it has been found that the solder is drained away from the leads 52a and solder bridging between the leads can be avoided. The optimum pivot axis of the component 52 on the board 28 can be found by pre-production trials, but extends in the Y direction and typically will be in the region of an end wall 58 of the pot 8 and depends on the pot and the component.

After the board 28 is lifted away from the pot 6, the X-Y mechanism is then actuated to move the board 28 in the X direction to position a second board component 54 over the pot. The pot 6 is replenished if necessary to raise the meniscus 10 to the datum level and the board lowered, horizontally, to dip the leads 54a into the meniscus 10. The motors 44,46 are then actuated to raise the board, again pivoting it about an axis predetermined for the component/pot combination.

Referring to Figure 2, the operation of the applicator 2 and the component handling mechanism 4 is microprocessor controlled by a CPU 60.

The CPU 60 controls the movement of the X-Y mechanism and suckers 26 to pick-up, position, and release the PCB 28. The X-Y mechanism is controlled to position the component handling mechanism 4 with the board 28 positioned above the pot 6. The positioning of the board relative to the pot is pre-programmed by an operator using the keyboard 62. To help position the board, the pot 6 may be replaced by a laser diode which will illuminate a spot on the board to show when a set of leads 52a, 54a etc., is in position above the pot 6.

The control of the motors 44,46 is programmed to operate the motors 44,46 to pivot the board about an axis in line with the nozzle edge 58 or some other predetermined pivot axis when raising the board. The position of the motors is determined by the X-Y mechanism, and so the CPU is programmed to operate the motors accordingly. It will be appreciated that when raising the board, the motors may operate to drive the shafts 36,38 in opposite directions to achieve the required pivoting motion of the board 28.

The operation of the applicator 2 is also controlled by the CPU 60 in accordance with information from the X-Y mechanism to show that a board has moved into position from the loading station, and from the sensor 20,22 to detect the height of the meniscus 10.

Figure 4 illustrates the process of lifting the leads away from the solder surface at an angle, to avoid solder bridging.

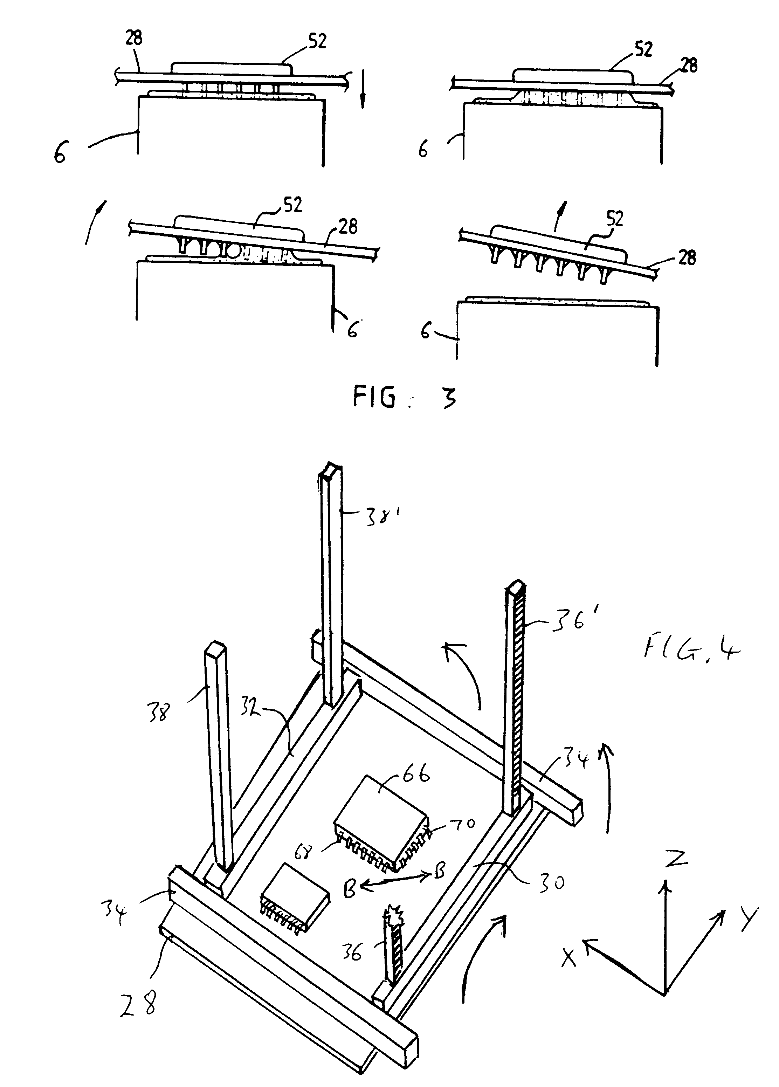

When using an elongate cross-section nozzle 6, such as shown in Figure 3, groups of leads extending in the transverse, Y, direction can be soldered by rotating the board 28 ninety degrees in the X-Y plane, relative to the table 24.
In a particularly preferred manner of operation, the PCB is rotated in a plane at a diagonal to facilitate soldering of components having leads arrayed in a square, for example. This can be achieved by rotating the board through, say, 45 degrees in the horizontal, XY plane before vertical rotation.

In a modification of the embodiment of Figure 1, a nozzle is provided which extends in the Y direction, transverse to the elongate direction of pot 6. Each rail 30, 32 is lifted by two lifting mechanisms as shown schematically in Figure 4. Ball and socket connections may be provided between the rails and the respective racks 36, 38, 36', 38' and a combination of ball joints and sliding joints may be provided where the rails 30, 32 connect to the beams 34. Thus, the PCB can be rotated about an axis extending in the X or Y direction and also about a diagonal axis without the need to rotate the board in the horizontal plane.

Referring to Figure 4, the component 66 on the PCB 28 has rows of leads 68, 70 which extend in the X and Y directions. To solder the component leads to the underside of the PCB 28, the leads are dipped into a large square cross-section pot (not shown) and lifted from the solder by rotating the board in a plane which is at an angle to both rows of leads, ie generally about the axis B-B.

It will be appreciated that the board may be translated vertically, in the Z direction, as it is rotated. Also, as mentioned above, it is possible to rotate the PCB 28 about a horizontal axis as the component leads are lowered into the solder, so that those leads which are withdrawn first from the solder are the first to enter the solder, thus providing a more uniform degree of heating of the leads.

Various modifications to the described embodiments will be apparent to those in the art and it is desired to include all such modifications as fall within the scope of the accompanying claims.

## Claims

1. Dip soldering apparatus for soldering to a PCB components having a plurality of leads, comprising a container for molten solder, means for lowering the board and means for raising the board to dip the leads of components or groups of components in turn into the surface of the solder, wherein the means for raising the board include means for rotating the board about a substantially horizontal axis as the leads are removed from the solder surface, the axis of rotation of the board being determinable for each component or group of components in turn.

2. Apparatus as claimed in claim 1, wherein means for rotating the board comprise independently controlled electric motors.

3. Apparatus as claimed in claim 1 or 2, wherein means is provided for rotating the board in a horizontal plane.

4. Apparatus as claimed in claim 1, 2 or 3, wherein means is provided for rotating the board about an axis at an angle to a row of component leads.

5. Apparatus as claimed in any one of claims 1 to 4, wherein means is provided to rotate the board about each of two axes at an angle to one another.

6. A method of soldering components to a printed circuit board, comprising dipping component leads into molten solder and rotating the board as the leads are withdrawn from the solder, characterised in that leads of two or more components or groups of components are soldered in turn, and the rotation of the board is determined separately for each component or group.

7. A method as claimed in claim 6, wherein the axis of rotation is determined separately for each component or group.

8. A method as claimed in claim 7 or 8, wherein the board is rotated about an axis which is at an angle to a row of leads which is being soldered.

9. A method as claimed in any one of claims 6 to 8, wherein the respective axes of rotation for two components or groups are at an angle to each other.

10. A method as claimed in claim 9, wherein the board is rotated as the leads are dipped into the molten solder.

11. A method of soldering a component to a PCB, comprising rotating the PCB as component leads are dipped into a molten solder, and rotating the PCB in the opposite direction as the leads are withdrawn fro the solder.

12. A method of soldering a component to a PCB, comprising dipping a row of leads of the component into molten solder and rotating the board about an axis which is transverse to the direction of the row of leads.
